# EUROPEAN PATENT SPECIFICATION

(11) **EP 0 543 582 B1**
(45) Date of publication and mention of the grant of the patent: **16.08.1995**
(21) Application number: 92310401.2
(22) Date of filing: 13.11.1992
(51) Int. Cl.: G06F 11/20, G06F 1/26, G11C 5/14

(54) **Data processing system including a memory system**
Datenverarbeitungsanordnung mit Speicheranordnung
Système de traitement de données avec système de mémoire

(30) Priority: 20.11.1991 US 795215
(43) Date of publication of application: 26.05.1993
(73) Proprietor: International Business Machines Corporation, Armonk, N.Y. 10504 (US)
(72) Inventor: Hartung, Michael Howard, Tucson, Arizona 85715-2848 (US); Singh, Shanker, California 95037 (US); Wade, Forrest Lee, Tucson, Arizona 85718 (US)
(74) Representative: Burt, Roger James, Dr.

(56) References cited:
- DE-A- 3 311 881
- COMPUTER SOCIETY INTERNATIONAL CONFERENCE (COMPCON). vol. 33, 1988, IEEE,WASHINGTON D.C.,US pages 146 - 151 MENON ET AL. 'The IBM 3990 disk cache'

## Description

This invention relates to a data processing system which includes storage devices which provide for prevention of loss of data and particularly to prevention by providing backup storage means having a separate source of power.

Cache memories operate at high speeds commensurate with the speeds of modern processors and form an interface with larger volume but slower main memories or system storage devices. Cache memories are usually made up of semi-conductor arrays which lose data when power is lost, i.e., are volatile. System storages such as a DASD (direct access storage device) are non-volatile, i.e., do not lose data when power fails, but access to the data is precluded until power is restored.

Some cache memories are of the write-through type where any write to the cache is also written into the system storage. The system storage is therefore up to date and contains the new data if the cache memory fails. Another type of cache memory stores blocks of data that are written to the system storage in a burst mode, for example. If a power failure occurs before a block of data is transferred to the system storage, the data is lost.

Non-volatile memories or stores (NVS) can be used to preserve data integrity by using battery power backup in case of power failure Economic considerations of the cost of NVS usually precludes implementation on a scale sufficiently large enough to be useful in high data volume applications. There are also technological differences between cache memories and NVS. For example, cache memories commonly use Drops (Dynamic Random Access Memories) which require periodical refreshing of the stored data. NVS, on the other hand, is usually implemented in SRAM (Static Random Access Memory) to eliminate the refresh requirements of DRAMs. The interfaces are also different.

Implementation of cache memories that are dependable in circumstances where power reliability is questionable has resulted in schemes which are not suitable for every application.

U.S. patent 4,849,978 discloses a plurality of storage units having a single backup memory unit. The backup memory unit contains the check sum of all the data stored in the other storage units so that, in the event of failure of any of the other memory units, its contents can be reconstructed from the data in the remaining other memory units and the check sum data in the backup unit.

U.S. patent 4,399,524 shows a random access memory having an auxiliary battery power supply and a detector on the main power supply to the memory that, if the main power supply voltage drops below a predetermined threshold, disconnects the processor from the memory to conserve power.

U.S. patent 4,603,406 discloses two memories, each having a backup power source and supplying a signal to indicate failure of the battery system. Inconsistent backup states are resolved as successful only when the sending memory is in a successful backup state and the receiving memory is the same state as the sending memory. U.S. patent 4,627,000 shows an electric meter with a non-volatile memory for saving the contents of a replaceable demand register in the event power is lost or the volatile demand register is removed.

U.S. patent 4,819,154 discloses a non-write-through cache memory for each processor in a system for storing computations of the associated processor. The data is then selectively written sequentially to two main memories, each having a status area up-dated by the processor before and after each writing operation. The transfer of data is made more efficient by using block status records that indicate whether an associated block has been altered. Only modified blocks are then transferred at designated times.

The prior art systems have disadvantages in the terms of cost and applicability to large data volume systems such as DASD (Direct Access Storage Device).

The paper titled "The IBM 3990 Disk Cache" by J Menon et al Computer Society International Conference, Vol 33, 1988 IEE Washington pp 146-151 describes a memory system having clusters of cache memory and separate clusters of non-volatile memory.

Viewed from one aspect the present invention provides a data processing system including a memory system, the memory system comprising: a plurality of split memory modules; a plurality of power supplies, each for supplying power to a separate one of the memory modules; characterised by each module having a first section comprising a cache memory and a second section comprising a non-volatile memory; and means for storing the same data in the first section of one of the memory modules and, at the same time, in the second section of a different one of the memory modules.

In accordance with the present invention a memory system can be viewed as a combination of split memory modules, each module partitioned into a cache section and a non-volatile section. Each module has its own power source so that the failure of a single power source will not affect the other modules. A particular block of data is not stored in both sections of a single module. Each modified block of data is stored in the cache section of one module and the non-volatile section of a different module. Therefore, the failure of any combination of power supplies will not result in the loss of any modified data since the non-volatile sections' power sources are backed up, usually by battery sources. In accordance with the invention, a data storage system is comprised of a plurality of cache memories and an equal number of non-volatile memories, each pair of a cache memory and non-volatile memory being connected to an independent power supply. Modified data is stored in both a cache memory and non-volatile memory of different pairs, i.e., so that each is not coupled to the same power source.

In order that the invention may be fully understood a preferred embodiment thereof will now be designated, by way of example only, with reference to the accompanying drawings in which:
FIG. 1 is a block diagram of a memory system in accordance with the present invention; and
FIG. 2 is a block diagram of a computer system which may incorporate the present invention.

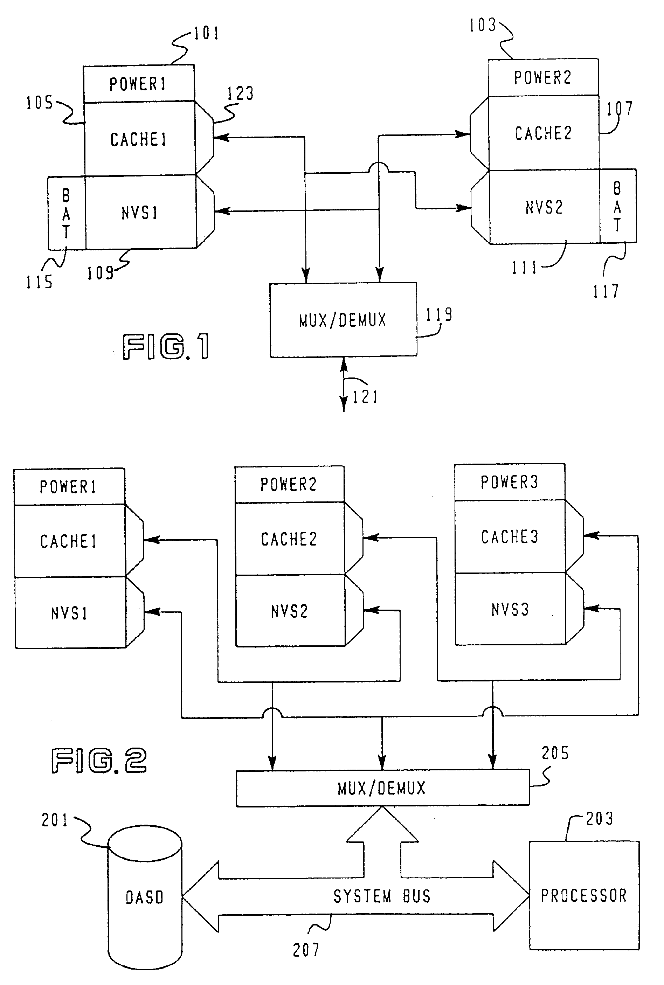

FIGURE 1 shows an embodiment of the invention using a pair of memory systems, each system comprising a cache memory and a non-volatile storage. Access to the memories for writing is such that the information is written into the cache memory of one system and at the same time, into the non-volatile storage of the other system. For example, information to be stored arriving on a system bus 121 is controlled by a multiplexor-de-multiplexor (MUX/DEMUX) 119. Information to be written is stored in a cache memory 105 via an interface 123 and, at the same time, stored in the non-volatile storage NVS2 111.

The power supplies for the separate systems are shown as POWER1 101 for the CACHE1 memory 105 and the NVS1 memory 109. Power supply POWER2 103 supplies power to the CACHE2 memory 107 and the NVS2 memory 111. A battery backup is supplied for the NVS1 memory 109 by a battery source 115. Battery source 117 backs up the non-volatile storage 111.

During normal operation, memory data is read to and from the cache memories 105 or 107 as determined by the MUX/DEMUX 119. Information that is written to the cache memories are also written to the opposite system non-volatile store. If the power supply fails for a particular system, then the data in the cache memory associated with the failed power supply can be read from the non-volatile storage in the other system. The cache memory for the non-volatile store and the system having a failed power supply is retained by means of the battery backup. If both power supplies fail, the information is still available from the non-volatile storages.

FIGURE 2 shows a larger memory system having three systems and a MUX/DEMUX 205 where the battery backup supplies from the non-volatile storages are not shown. A system bus 207 is shown coupled to a processor 203 and a DASD system 201 and the MUX/DEMUX 205 for the memory system. The cache memories, CACHE1, CACHE2, and CACHE3, are addressed by contiguous address fields under the control of the interface to each cache and the operation of the MUX/DEMUX 205. Similarly, the non-volatile storage systems, NVS1, NVS2 and NVS3, are similarly addressed except that the data stored in NVS1 contains the modified data that is stored in CACHE3, that NVS2 is similarly paired with CACHE1, and NVS3 is similarly paired with CACHE2. The power supplies, POWER1, POWER2 and POWER3, are independent from one another and cause a failure only in the system cache to which they supply power. As can be seen from FIGURE 2, the information stored in the memory can survive even if failure of all three power supplies using the arrangement shown.

Although the invention has been described in terms of cache memories and non-volatile storage, it is not intended to be limited to any particular type of memory.

## Claims

1. A data processing system including a memory system, the memory system comprising:
a plurality of split memory modules; a plurality of power supplies (101,103), each for supplying power to a separate one of the memory modules; characterised by each module having a first section (105,107) comprising a cache memory and a second section (109,111) comprising a non-volatile memory;
and means for storing the same data in the first section of one of the memory modules and, at the same time, in the second section of a different one of the memory modules.

2. A data processing system as claimed in claim 1 further comprising:
means for coupling each of the power supplies to a separate one of the cache memories and to a separate one of the non-volatile memories.

3. A data processing system as claimed in any of the preceding claims further comprising:
transfer means (119) for coupling addresses and data to or from a source in parallel to one of the cache memories and one of the non-volatile memories not coupled to the same power supply.

## Patentansprüche

1. Eine Datenverarbeitungsanordnung mit Speicheranordnung, wobei die Speicheranordnung folgendes umfaßt:
eine Mehrzahl getrennter Speichermodule; eine Mehrzahl an Stromversorgungseinrichtungen 101, 103, von denen jede Strom an ein separates Speichermodul liefert; dadurch charakterisiert, daß jedes Modul einen ersten Bereich 105, 107, der einen Cache-Speicher umfaßt, und einen zweiten Bereich 109, 111, der einen nichtflüchtigen Speicher umfaßt, aufweist;
und ein Mittel zur Speicherung derselben Daten im ersten Bereich eines der Speichermodule und gleichzeitig im zweiten Bereich eines anderen Speichermoduls.

2. Eine Datenverarbeitungsanordnung gemäß Anspruch 1, des weiteren bestehend aus:
einem Mittel zur Kopplung jeder der Stromversorgungen an einen separaten Cache-Speicher und an einen separaten nichtflüchtigen Speicher.

3. Eine Datenverarbeitungsanordnung gemäß allen vorherigen Ansprüchen, des weiteren bestehend aus:
einem Übertragungsmittel (119) zur Kopplung von Adressen und Daten an eine oder von einer Quelle parallel zu einem der Cache-Speicher und einem der nichtflüchtigen Speicher, die nicht an dieselbe Stromversorgung angeschlossen sind.

## Revendications

1. Système de traitement de données avec système de mémoire, le système de mémoire comprenant:
une pluralité de modules de mémoire découpés; une pluralité de sources d'alimentation (101, 103) pour fournir chacune de l'énergie à un module de mémoire distinct parmi les modules de mémoire; caractérisé en ce que chaque module a une première section (105, 107) constituée d'une antémémoire et une deuxième section (109, 111) constituée d'une mémoire non volatile; et
des moyens pour emmagasiner les mêmes données dans la première section de l'un des modules de mémoire, et, en même temps, dans la deuxième section d'un module différent parmi les modules de mémoire.

2. Système de traitement de données selon la revendication 1, comprenant en outre:
des moyens pour coupler chacune des sources d'alimentation à une antémémoire distincte parmi les antémémoires et à une mémoire non volatile distincte parmi les mémoires non volatiles.

3. Système de traitement de données selon l'une quelconque des revendications précédentes, comprenant en outre:
des moyens de transfert (119) pour coupler des adresses et des données à une source, ou à partir de celle-ci, en parallèle à l'une des antémémoires et à l'une des mémoires non volatiles non couplées à la même source d'alimentation.
